# FASCICULE DE BREVET EUROPEEN

(11) **EP 1 003 079 B1**
(45) Date de publication et mention de la délivrance du brevet: **06.05.2004**
(21) Numéro de dépôt: 99470020.1
(22) Date de dépôt: 10.11.1999
(51) Int. Cl.: G03F 7/30

(54) **Procédé pour la confection de clichés souples et dispositif pour la mise en oeuvre du procédé**
Verfahren zur Herstellung von flexiblen Druckplatten und Gerät zur Ausführung des Verfahrens
Process for the production of flexible printing plates and device therefor

(30) Priorité: 17.11.1998 FR 9814516
(43) Date de publication de la demande: 24.05.2000
(73) Titulaire: PHOTOMECA, 54340 Pompey (FR)
(72) Inventeur: Brazier, David, High Wycome, Buckinghamshire HP13 6QR (GB)
(74) Mandataire: Poupon, Michel

(56) Documents cités:
- EP-A- 0 572 342
- EP-A- 0 592 343
- US-A- 5 436 105
- PATENT ABSTRACTS OF JAPAN vol. 012, no. 079 (P-676), 12 mars 1988 (1988-03-12) & JP 62 217249 A (ASAHI CHEM IND CO LTD), 24 septembre 1987 (1987-09-24)

## Description

La présente invention concerne un procédé pour la réalisation de clichés souples à partir d'une plaque photopolymère, lesdits clichés étant utilisables pour la réalisation d'imprimés par les méthodes de flexographie, typographie ou offset sec, et plus particulièrement l'étape de brossage de la plaque photopolymère permettant la réalisation de ces clichés.

La présente invention concerne également un dispositif permettant de mettre en oeuvre le procédé selon l'invention.

La réalisation de tels clichés souples est habituellement opérée en exposant une plaque photopolymère sensible aux rayonnements ultraviolets, et en interposant un film négatif qui laisse exposée au rayonnement les zones qui doivent venir en relief sur le cliché lorsqu'il est terminé. Le rayonnement durcissant ces zones, on élimine ensuite la matière de la surface protégée en la brossant à l'aide de brosses planes ou rotatives et d'un solvant ou d'une base aqueuse suivant le type de plaque.

Dans le procédé selon l'invention, le brossage de la face exposée de ladite plaque est opéré par un ensemble de brosse composé d'un alignement de brosses planes à surfaces de brossage sensiblement rectangulaires, lesdites brosses subissant chacune un mouvement de rotation horizontale et ledit ensemble de brosse subissant en outre un mouvement de translation horizontale alterné.

L'art antérieur connaît déjà des procédés de réalisation de clichés souples et notamment la demande de brevet européen N° 0 592 343 dont le demandeur est titulaire, qui présente un procédé automatisé pour la confection de clichés souples à partir d'une plaque introduite face sensible tournée vers le haut, ainsi qu'un dispositif de mise en oeuvre du procédé.

La présente invention constitue un perfectionnement de cette précédente demande.

L'art antérieur connaît également, des schémas illustrant le brevet US -A- 5 436105, un procédé de brossage combinant à la fois un brossage en va et vient horizontal dans une direction transversale au sens d'avancé de la plaque photopolymère et un brossage en rotation à l'aide de brosses à surfaces de brossage circulaires, mais ce type de brossage engendre un inconvénient majeur : les contraintes mécaniques crées sur la plaque photopolymère par les différents mouvements sont telles qu'elles s'opposent à une progression uniforme et précise de la plaque photopolymère dans la section de brossage.

La présente invention entend remédier aux inconvénients de l'art antérieur en proposant que chaque brosse soit décalée de 180° dans sa rotation horizontale par rapport à la brosse immédiatement adjacente ou aux deux brosses immédiatement adjacentes dans l'alignement de brosses.

Ainsi, la rotation de la ou des deux brosses immédiatement adjacentes à chaque brosse a pour effet d'annuler les contraintes provoquées par la rotation de cette brosse sur la plaque photopolymère et la plaque photopolymère peut alors progresser dans la section de brossage avec la précision requise.

Le but principal de l'invention est à la fois de parfaire l'étape de brossage présentée dans la demande de brevet européen N° 0 592 343 et de permettre une réalisation encore plus rapide de cette étape, en la réalisant en mode continu.

Avantageusement, la section de brossage, qui est délimitée par les positions extrémales des brosses tout au long du brossage, permet de brosser des plaques photopolymères selon leurs largeurs, et quelles que soient leurs longueurs.

Avantageusement également, lorsque le mouvement de translation horizontale alternée de l'ensemble de brosses est opéré selon une direction perpendiculaire au sens d'avancement de la plaque photopolymère dans la section de brossage, toute la surface de la plaque photopolymère est brossée par au moins deux brosses adjacentes.

Concernant la transmission du mouvement de rotation, l'invention préconise de disposer à chaque extrémité des brosses au moins un arbre de transmission du type manivelle et d'entraîner les manivelles en rotation à l'aide d'un moteur unique.

On comprendra mieux l'invention à l'aide de la description faite ci-après de l'invention à titre purement explicatif en référence aux figures annexées :
- la figure 1 illustre une vue en perspective de la section de brossage où est mis en oeuvre le procédé selon l'invention ;
- la figure 2 illustre une brosse selon l'invention munie de deux manivelles ; et
- la figure 3 illustre la décomposition du mouvement de rotation horizontal des brosses respectivement à 0°, 90°, 180° et 270° par rapport à une origine.

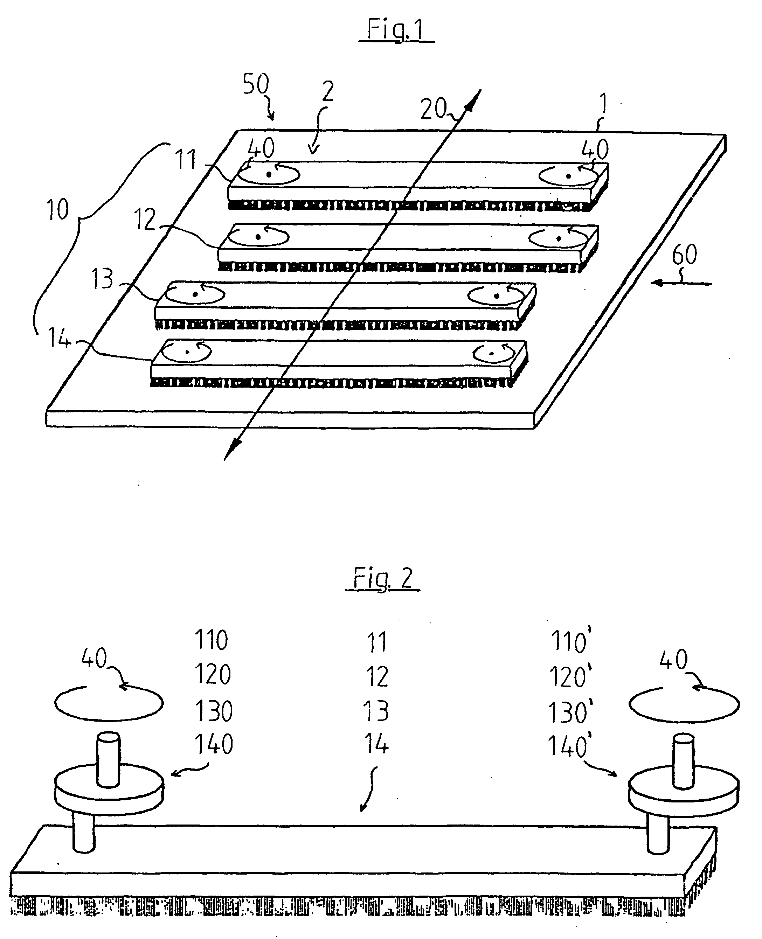

Le procédé selon l'invention, illustré figure 1, est un procédé pour la confection de clichés à partir d'une plaque (1) photopolymère préalablement exposée à un rayonnement ultraviolet afin de la transformer en clichés d'impression pour la flexographie, la typographie ou l'offset sec, du type comportant une étape de brossage de la face exposée de ladite plaque (1) par un ensemble de brosse (10) composé d'un alignement (2) de brosses (11,12,13,14) planes à surfaces de brossage sensiblement rectangulaires, lesdites brosses (11,12,13,14) subissant chacune un mouvement de rotation horizontale (40) et ledit ensemble de brosse (10) subissant en outre au moins un mouvement de translation horizontale alternée (20).

Le procédé selon l'invention est caractérisé en ce que chaque brosse (11,12,13,14) est décalée de 180° dans sa rotation horizontale (40) par rapport à la brosse immédiatement adjacente ou aux deux brosses immédiatement adjacentes dans ledit alignement (2) de brosses.

Ainsi, les contraintes provoquées sur la plaque (1) par la rotation de chaque brosse sont annulées par les contraintes provoquées en sens contraire sur la plaque (1) par la rotation de la brosse immédiatement adjacente ou aux deux brosses immédiatement adjacentes dans ledit alignement (2) de brosses.

Le procédé selon l'invention est en outre caractérisé en ce que l'opération de brossage est opérée en continu dans une section de brossage (50) par avancement (60) à vitesse constante de la plaque (1) à travers ladite section de brossage (50).

Ainsi, le brossage de la plaque photopolymère en continu selon l'invention s'insère parfaitement dans le procédé de réalisation de clichés souples en continu.

La section de brossage (50) est définie par les positions extrémales des brosses, c'est à dire d'un part par les positions les plus avancées et les plus reculées selon le sens de l'avancement (60) et d'autre part, par les positions les plus avancées et les plus reculées selon une direction perpendiculaire au sens de l'avancement (60).

De préférence, la plaque (1) photopolymère est introduite dans la section de brossage (50) perpendiculairement à la largeur des brosses (11,12,13,14), c'est à dire, dans la direction de la longueur des brosses (11,12,13,14), afin que le brossage soit plus efficace.

La section de brossage (50) est telle qu'elle ne couvre pas nécessairement la longueur entière de la plaque (1) photopolymère, mais elle couvre au moins la largeur de la plaque (1) par rapport à la direction de l'avancement (60). De cette manière, le procédé permet de réaliser des clichés de grande longueur, qui étaient jusqu'à maintenant impossibles à réaliser.

De préférence, la vitesse de la rotation horizontale (40) de chaque brosse (11,12,13,14) est constante et identique en sens et en intensité à celle des autres brosses.

De préférence également, l'ensemble des rotations horizontales (40) est réalisé à l'aide d'un moyen d'entraînement en rotation, du type moteur, unique.

Il est important de noter que la vitesse du mouvement de translation horizontale alterné (20), à la différence de celle du mouvement de rotation horizontale (40) ne joue aucun rôle dans la réalisation du brossage multidirectionnel nécessaire pour former le relief idéal.

Le mouvement de translation horizontale alterné (20) n'a d'utilité que pour l'égalisation du brossage sur toute la surface à brosser.

Il peut être réalisé à une vitesse lente pour minimiser les risques de mouvements de la plaque (1) photopolymère durant le brossage.

De cette façon toutes les portions de la plaque (1) qui doivent être brossées, le sont parfaitement et rapidement.

Le dispositif pour la mise en oeuvre du procédé selon l'invention est du type comportant un ensemble de brosse (10) composé d'un alignement (2) de brosses (11,12,13,14) planes à surfaces de brossage sensiblement rectangulaires, lesdites brosses (11,12,13,14) subissant chacune un mouvement de rotation horizontale (40) et ledit ensembie de brosse (10) subissant en outre au moins un mouvement de translation horizontale alternée (20).

Le dispositif selon l'invention est caractérisé en ce que chaque brosse (11,12,13,14) est entraînée en rotation horizontale (40) par l'intermédiaire d'au moins une manivelle (110,110', 120,120', 130,130', 140,140'), comme illustré figure 2.

De préférence, chaque brosse (11,12,13,14) est entraînée en rotation horizontale (40) par l'intermédiaire respectivement de deux manivelles (110,110'), (120,120'), (130,130'), (140,140').

Chaque manivelle comporte un axe d'entrée, entraîné en rotation par des moyens de mise en rotation et un axe de sortie directement lié à la brosse.

Les axes d'entrée de chaque manivelle sont décalés par rapport aux axes de sortie, mais les axes d'entrée de chaque paire de manivelles sont entraînés ensemble en rotation et tourment à la même vitesse, de préférence grâce à un moyen de mise en rotation unique et à des moyens de transmissions inversés d'une brosse adjacente à l'autre selon l'alignement (2).

Ainsi, les axes de sortie de chaque paire de manivelles sont toujours dans la même position angulaire, et provoquent toujours le même mouvement de rotation horizontale (40) des brosses (11,12,13,14).

En outre, les axes de sortie de chaque paire de manivelles sont toujours dans la même position angulaire que les axes de sortie de chaque paire de manivelles de la ou des brosses situées juste après la ou les brosses immédiatement adjacentes dans l'alignement (2).

Le nombre de brosses est essentiellement fonction de la largeur de la section de brossage que l'on souhaite couvrir.

Les brosses (11,12,13,14) sont de préférence en nombre paire.

Si l'avancement (60) est très rapide, il est bien sûr possible de juxtaposer une pluralité de section de brossage (50) selon le sens d'avancement (60), afin de parfaire le brossage.

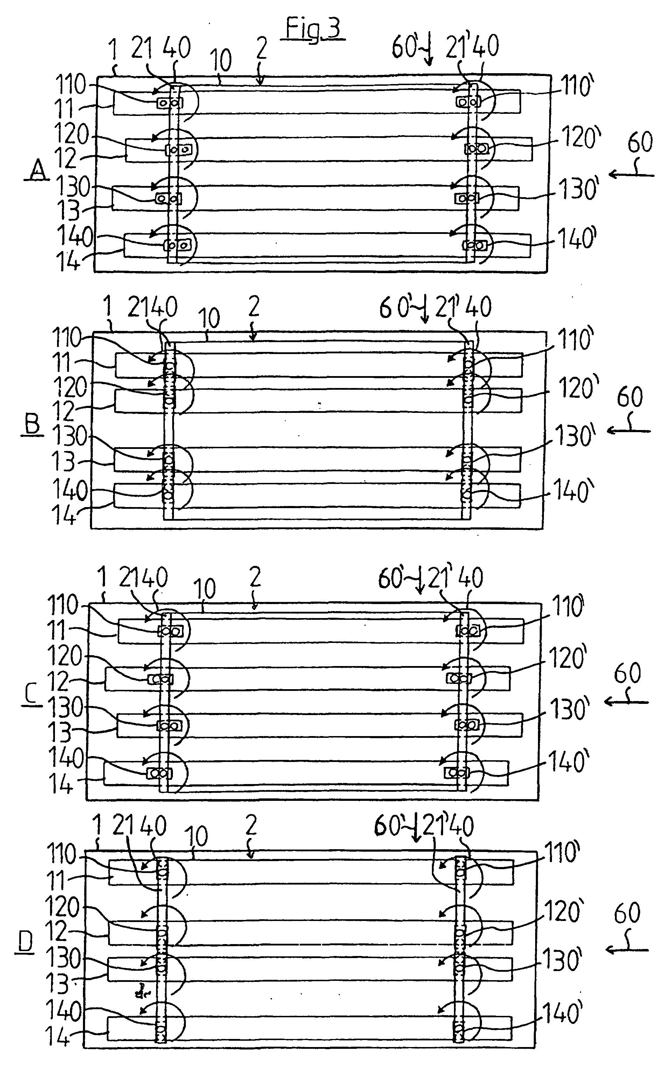

La figure 3 illustre un exemple de décomposition du mouvement de rotation horizontale (40) et du décalage à 180° entre deux brosses immédiatement adjacentes dans l'alignement (2).

Pour des raisons de clarté, le mouvement de translation horizontale alternée (20) n'est pas illustré sur cette figure et les manivelles (110,110', 120,120', 130,130', 140,140') présentent des plaques de déport rectangulaires et non circulaires, comme illustré figure 2.

Si on pose que le dessin A illustre une situation d'origine, par rapport au sens de la rotation horizontale (40) considéré, le dessin B illustre alors une position des brosses après une rotation de 90° par rapport à la situation illustrée sur le dessin A, le dessin C illustre alors une situation des brosses après une rotation de 180° par rapport à la situation illustrée sur le dessin A et le dessin D illustre alors une situation des brosses après une rotation de 270° par rapport à la situation illustrée sur le dessin A.

Si on prend l'exemple de la brosse (12), dans la situation A, la brosse (12) se trouve dans sa position la plus reculée par rapport au sens de l'avancement (60) et dans une position centrale par rapport au sens (60') défini arbitrairement ; dans la situation B, la brosse (12) se trouve dans sa position la plus reculée par rapport au sens (60') et dans une position centrale par rapport au sens de l'avancement (60) ; dans la situation C, la brosse (12) se trouve dans sa position la plus avancée par rapport au sens de l'avancement (60) et dans une position centrale par rapport au sens (60') ; et dans la situation D, la brosse (12) se trouve dans sa position la plus avancée par rapport au sens (60') et dans une position centrale par rapport au sens de l'avancement (60).

On voit ainsi clairement que dans toutes les situations A, B, C et D, la brosse (12) occupe une position qui est exactement à 180° des positions occupées par les brosses immédiatement adjacentes (11,13) dans l'alignement (2).

La figure 3 illustre par ailleurs le fait que le pas entre chaque brosse (11,12,13,14) formant l'alignement (2) est variable et que le pas entre les axes d'entrée des manivelles (110,120,130,140) d'une part et entre les axes d'entrée des manivelles (110',120',130',140') d'autre part sont toujours identiques grâce respectivement aux barres de maintient (21,21').

## Revendications

1. Procédé pour la confection de clichés à partir d'une plaque (1) photopolymère préalablement exposée à un rayonnement ultraviolet afin de la transformer en clichés d'impression pour la flexographie, la typographie ou l'offset sec, du type comportant une étape de brossage de la face exposée de ladite plaque (1) par un ensemble de brosse (10) composé d'un alignement (2) de brosses (11,12,13,14) planes à surfaces de brossage sensiblement rectangulaires, lesdites brosses (11,12,13,14) subissant chacune un mouvement de rotation horizontale (40) et ledit ensemble de brosse (10) subissant en outre au moins un mouvement de translation horizontale alternée (20), **caractérisé en ce que** chaque brosse (11,12,13,14) est décalée de 180° dans sa rotation horizontale (40) par rapport à la brosse immédiatement adjacente ou aux deux brosses immédiatement adjacentes dans ledit alignement (2).

2. Procédé selon la revendication 1, **caractérisé en ce que** l'opération de brossage est opérée en continu dans une section de brossage (50) par avancement (60) à vitesse constante de la plaque (1) à travers ladite section de brossage (50).

3. Procédé selon la revendication 1 ou la revendication 2, **caractérisé en ce que** la plaque (1) photopolymère est introduite dans la section de brossage (50) perpendiculairement à la largeur des brosses (11,12,13,14).

4. Procédé selon l'une quelconque des revendications 1 à 3, **caractérisé en ce que** la vitesse de la rotation horizontale (40) de chaque brosse (11,12,13,14) est constante et identique en sens et en intensité.

5. Procédé selon l'une quelconque des revendications 1 à 4, **caractérisé en ce que** l'ensemble des rotations horizontales (40) est réalisé à l'aide d'un moyen d'entraînement en rotation, du type moteur, unique.

6. Dispositif pour la mise en oeuvre du procédé selon l'une quelconque des revendications 1 à 4, du type comportant un ensemble de brosse (10) composé d'un alignement (2) de brosses (11,12,13,14) planes à surfaces de brossage sensiblement rectangulaires, lesdites brosses (11,12,13,14) subissant chacune un mouvement de rotation horizontale (40) et ledit ensemble de brosse (10) subissant en outre au moins un mouvement de translation horizontale alternée (20), **caractérisé en ce que** chaque brosse (11,12,13,14) est entraînée en rotation horizontale (40) par l'intermédiaire d'au moins une manivelle (110,110', 120,120', 130,130', 140,140').

7. Dispositif selon la revendication 6, **caractérisé en ce que** chaque brosse (11,12,13,14) est entraînée en rotation horizontale (40) par l'intermédiaire respectivement de deux manivelles (110,110'), (120,120'), (130,130'), (140,140').

## Patentansprüche

1. Verfahren zur Herstellung von Druckplatten, ausgehend von einer zuvor einer ultravioletten Strahlung ausgesetzten fotopolymeren Platte (1), um die Platte in Druckplatten für den Flexodruck, die Typographie oder den Trockenoffsetdruck umzuwandeln, wobei das Verfahren einen Schritt des Bürstens der der Strahlung ausgesetzten Fläche der genannten Platte (1) mittels einer Bürstenanordnung (10) umfasst, die durch ein Ausrichten (2) von ebenen Bürsten (11, 12, 13, 14) auf im wesentlichen rechteckigen zu bürstenden Oberflächen gebildet ist, wobei jede der genannten Bürsten (11, 12, 13, 14) eine horizontale Drehbewegung (40) ausführt und die genannte Bürstenanordnung (10) außerdem mindestens eine horizontale translatorische Wechselbewegung (20) ausführt, **dadurch gekennzeichnet, dass** jede Bürste (11, 12, 13, 14) während ihrer horizontalen Drehbewegung (40) gegenüber der unmittelbar benachbarten Bürste oder zwei unmittelbar benachbarten Bürsten in der genannten Ausrichtung (2) um 180° versetzt angeordnet ist.

2. Verfahren nach Anspruch 1, **dadurch gekennzeichnet, dass** der Bürstenvorgang in einem Bürstenbereich (50) durch Vorschub (60) der Platte (1) mit konstanter Geschwindigkeit im genannten Bürstenbereich (50) fortgesetzt wird.

3. Verfahren nach Anspruch 1 oder Anspruch 2, **dadurch gekennzeichnet, dass** die photopolymere Platte (1) in den Bürstenbereich (50) senkrecht zur Breite der Bürsten (11, 12, 13, 14) eingeführt wird.

4. Verfahren nach einem der Ansprüche 1 bis 3 **dadurch gekennzeichnet, dass** die Geschwindigkeit der horizontalen Drehbewegung (40) jeder Bürste (11, 12, 13, 14) konstant und identisch ist sowohl im Drehsinn als auch im Betrag.

5. Verfahren nach einem der Ansprüche 1 bis 4, **dadurch gekennzeichnet, dass** das System der horizontalen Drehbewegungen (40) durch ein einziges motorartiges Drehantriebsmittel realisiert wird.

6. Vorrichtung zur Durchführung des Verfahrens nach einem der Ansprüche 1 bis 4, mit einer Bürstenanordnung (10), die durch ein Ausrichten (2) von ebenen Bürsten (11, 12, 13, 14) auf im wesentlichen rechteckigen zu bürstenden Oberflächen gebildet ist, wobei jede der genannten Bürsten (11, 12, 13, 14) eine horizontale Drehbewegung (40) ausführt und die genannte Bürstenanordnung (10) außerdem mindestens eine horizontale translatorische Wechselbewegung (20) ausführt, **dadurch gekennzeichnet, dass** jede Bürste (11, 12, 13, 14) mittels mindestens einer Kurbel (110, 110', 120, 120', 130, 130', 140, 140') in horizontale Drehbewegung (40) versetzt wird.

7. Vorrichtung nach Anspruch 6, **dadurch gekennzeichnet, dass** jede Bürste (11, 12, 13, 14) mittels jeweils zweier Kurbeln (110, 110'), (120, 120'), (130, 130'), (140, 140') in horizontale Drehbewegung (40) versetzt wird.

## Claims

1. Method of manufacturing blocks from a photopolymeric plate (1), which has been previously exposed to ultraviolet radiation in order to transform it into printing blocks for flexography, typography or dry offset printing, of the type comprising a stage of brushing the exposed face of said plate (1) by a brush assembly (10) composed of a row (2) of planar brushes (11, 12, 13, 14) having substantially rectangular brushing surfaces, said brushes (11, 12, 13, 14) each being subjected to a horizontal rotational movement (40), and said brush assembly (10) also being subjected to at least one alternate horizontal movement of translation (20), **characterised in that** each brush (11, 12, 13, 14) is offset by 180° in its horizontal rotation (40) relative to the immediately adjacent brush or relative to the two immediately adjacent brushes in said row (2).

2. Method according to claim 1, **characterised in that** the brushing operation is effected continuously in a brushing section (50) by advancing (60) the plate (1) at a constant speed through said brushing section (50).

3. Method according to claim 1 or claim 2, **characterised in that** the photopolymeric plate (1) is introduced into the brushing section (50) perpendicularly to the width of the brushes (11, 12, 13, 14).

4. Method according to any of claims 1 to 3, **characterised in that** the speed of the horizontal rotation (40) of each brush (11, 12, 13, 14) is constant and identical in respect of direction and in respect of intensity.

5. Method according to any of claims 1 to 4, **characterised in that** all of the horizontal rotations (40) are carried out by means of a single rotational driving means, of the motor type.

6. Apparatus for accomplishing the method according to any of claims 1 to 4, of the type comprising a brush assembly (10) composed of a row (2) of planar brushes (11, 12, 13, 14) having substantially rectangular brushing surfaces, said brushes (11, 12, 13, 14) each being subjected to a horizontal rotational movement (40), and said brush assembly (10) also being subjected to at least one alternate horizontal movement of translation (20), **characterised in that** each brush (11, 12, 13, 14) is driven in horizontal rotation (40) through the intermediary of at least one handle (110,110', 120,120', 130,130', 140,140').

7. Apparatus according to claim 6, **characterised in that** each brush (11, 12, 13, 14) is driven in horizontal rotation (40) through the intermediary of two handles (110,110'), (120,120'), (130,130'), (140,140') respectively.
